# EUROPÄISCHE PATENTSCHRIFT

(11) **EP 0 885 552 B1**
(45) Veröffentlichungstag und Bekanntmachung des Hinweises auf die Patenterteilung: **09.02.2000**
(21) Anmeldenummer: 96946006.2
(22) Anmeldetag: 22.11.1996
(51) Int. Cl.: H05K 7/20

(54) **ELEKTRISCHES GERÄT**
ELECTRICAL DEVICE
DISPOSITIF ELECTRIQUE

(30) Priorität: 09.03.1996 DE 19609243
(43) Veröffentlichungstag der Anmeldung: 23.12.1998
(73) Patentinhaber: ROBERT BOSCH GMBH, 70442 Stuttgart (DE)
(72) Erfinder: BENTZ, Willy, D-74343 Sachsenheim (DE); DEPTULA, Piotr, D-72116 Mössingen (DE); ERNST, Waldemar, D-71665 Vaihingen (DE)
(86) Internationale Anmeldenummer: DE9602240
(87) Internationale Veröffentlichungsnummer: WO9733459

(56) Entgegenhaltungen:
- DE-A- 3 416 348
- DE-A- 3 545 253
- DE-A- 4 222 838
- DE-U- 9 015 130
- US-A- 5 225 965
- MOTOROLA TECHNICAL DEVELOPMENTS, Bd. 18, 1.März 1993, Seiten 42-43, XP000349553 FISHER T S ET AL: "ADHESIVELESS HEATSINK ASSEMBLY FOR VERTICAL POWER DEVICES"

## Beschreibung

### Stand der Technik

Die Erfindung betrifft ein elektrisches Gerät nach dem Oberbegriff des Hauptanspruchs.

Es ist bereits aus der DE-OS 42 22 838 ein elektrisches Gerät bekannt, bei dem Verlustwärme erzeugende Leistungsbauelemente für die Steuergeräteelektronik einer Motorsteuerung auf einer Leiterplatte in einem Gehäuse angeordnet sind.

Um die Verlustwärme von Leistungsbauelementen bei elektronischen Steuergeräten mit einer Leiterplatte abzuleiten, erfolgt die Montage der Leistungsbauelemente auf einer Kühlfläche. Die Anzahl der Leistungsbauelemente ist daher durch den zur Verfügung stehenden Raum auf den Kühlflächen und die maximal ableitbare Verlustleistung begrenzt. Die für die sonstigen Schaltungselemente zur Verfügung stehende Layoutfläche auf der Leiterplatte reduziert sich somit durch die Befestigungsstellen der Leistungsbauelemente an den als Wärmesenke wirkenden Kühlflächen.

Da bei den elektronischen Schaltungskonzepten in zunehmenden Masse Leistungsbauelemente auf Halbleiterbasis an die Stelle von elektromechanischen Bauelementen, wie z.B. Relais, treten, erhöht sich die Zahl dieser zu verwendenden Leistungsbauelemente und darüber hinaus nimmt auch der Umfang der Schaltung und der sonstigen Bauelemente durch eine ausgefeilte Elektronik zu. Eine Volumenvergrößerung der elektrischen Geräte ist jedoch nicht wünschenswert.

### Vorteile der Erfindung

Das erfindungsgemäße elektrische Gerät mit den kennzeichnenden Merkmalen des Anspruchs 1 ist insbesondere dadurch vorteilhaft, daß durch die komplexe Unterbringung von Leistungsbauelementen an besonderen Stegen an dem Gehäuserahmen zusätzlicher Raum für eine Anzahl von Leistungsbauelementen bei optimaler Ausnutzung der Layoutfläche auf der Leiterplatte gewonnen ist. Durch den thermischen Kontakt der Stege zu dem Gehäuserahmen ist eine gute Abfuhr der Verlustleistung an weitere Wärmesenken gewährleistet.

Dadurch, daß die Stege abgesetzt von der jeweiligen Gehäuserahmenwand angeordnet sind, ist eine elektrisch sinnvolle Schaltungsaufteilung mit einer geringen Anzahl von Verbindungsleitungen auf der Leiterplatte möglich. Die erforderliche Layoutfläche läßt sich somit gering halten, so daß in vielen Fällen eine sonst notwendige zusätzliche Leiterplatte mit zusätzlichen Kühlkörpern entfallen kann. Durch den hier möglichen kompakten Aufbau ist auch eine hervorragende Abschirmung der Schaltung und somit ein gutes EMV-Verhalten des elektrischen Geräts erreichbar. Die Verlustleistung der Leistungsbauelemente in Form von Wärme kann mittel der Stege direkt vom Gehäuserahmen über den Gehäuseboden an die Umgebung abgeführt werden.

Besonders vorteilhaft ist es, wenn die Leiterplatte mit der relativ empfindlichen elektrischen Schaltung auf der dem Gehäuseboden gegenüberliegenden Seite des Gehäuserahmens liegt. Hierdurch kann die abzuführende Verlustleistung erheblich erhöht werden, da die Verbindung zwischen dem Gehäuserahmen und dem Gehäuseboden großflächig ausgelegt und auch eine hohe Zahl von Verbindungsstellen (Verschraubungen) vorgesehen werden kann. Die für das Leiterplattenlayout verfügbare Fläche ist hierbei relativ groß, da die Leiterplatte nicht durch Aussparungen, die sonst zur Wärmeableitung notwendig sind, unterbrochen ist.

Vorteilhafte Ausbildungen des erfindungsgemäßen elektrischen Geräts sind in den Unteransprüchen angegeben, wobei insbesondere die Anordnung von Quer- und/oder Längsstegen in Abhängigkeit vom jeweiligen Anwendungsfall vorgesehen werden kann.

### Zeichnung

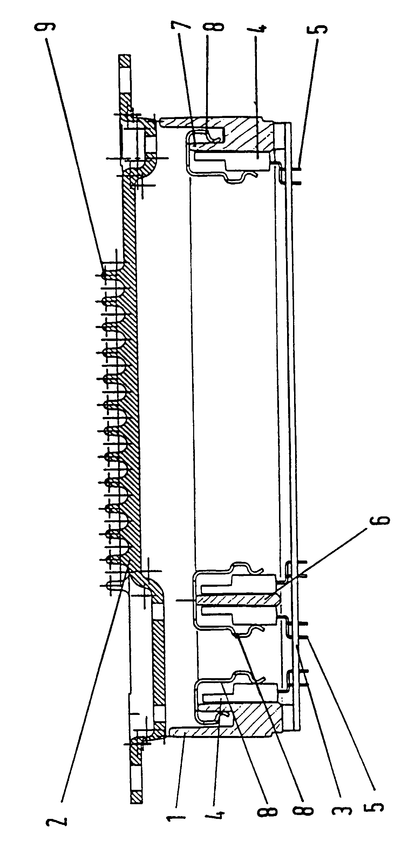

Ein Ausführungsbeispiel des erfindungsgemäßen elektrischen Geräts wird anhand der Figur, die einen Schnitt durch ein elektrisches Gerät mit Leistungsbauelementen auf einer Leiterplatte zeigt, erläutert.

### Beschreibung des Ausführungsbeispiels

Nach der Schnittdarstellung eines elektrischen Geräts in der Figur ist ein Gehäuserahmen 1 an einem metallischen Gehäuseboden 2 fest über hier nicht dargestellte Schraubverbindungen gehalten, so daß ein thermischer Kontakt hergestellt ist. Auf einer ebenfalls am Gehäuserahmen 1 befestigten Leiterplatte 3 sind eine Anzahl von Leistungsbauelementen 4 mit ihren elektrischen Anschlüssen 5 aufgelötet. Die Leistungsbauelemente 4 sind mit ihren wärmeführenden Gehäuseteilen zur Ableitung der Verlustleistung an Querstegen 6 bzw. an Längsstegen 7 gehalten. Zur besseren Halterung und zur Gewährleistung eines guten thermischen Kontaktes zum Gehäuserahmen 1 sind diese mittels metallischer Klammern 8 an die Stege 6 bzw. 7 angedrückt.

Der mit Rippen 9 zur Oberflächenvergrößerung versehene Gehäuseboden 2 ist bei diesem Ausführungsbeispiel an der, der Leiterplatte 3 gegenüberliegenden Seite des Gehäuserahmens 1 angebracht, wodurch die Wärmeabgabe an die Umgebung erfolgt, ohne die Leiterplatte 3 zu beeinträchtigen. Die für die äußeren Anschlüsse notwendigen Steckerteile können in gewohnter Weise an die Leiterplatte 3 angebracht werden.

Weiterhin können zusätzliche Gehäuseteile angefügt, bzw. auch durch die Aggregate, an denen das elektrische Gerät angebracht wird, gebildet werden.

## Patentansprüche

1. Elektrisches Gerät, mit einer zumindest teilweise auf einer Leiterplatte (3) angeordneten, elektronischen Schaltung, wobei die Schaltung Leistungsbauelemente (4) mit jeweils einer Anordnung zu einer Wärmeableitung aufweist dadurch gekennzeichnet, daß das Gerät einen Gehäuserahmen (1) für die elektronische Schaltung aufweist, daß der Gehäuserahmen (1) eine Anzahl von, mit der jeweiligen Gehäuserahmenwand verbundene, aber abgesetzte Stege (6, 7) aufweist, an denen die wärme führenden Gehäuseteile der Leistungsbauelemente (4) unter thermischem Kontakt gehalten sind, daß der Gehäuserahmen (1) an einen wärmeableitenden Gehäuseboden (22) unter thermischen Kontakt anfügbar ist und daß die Leiterplatte (3) der elektronischen Schaltung auf der dem Gehäuseboden (2) der elektromechanischen Anordnung gegenüberliegenden Seite des Gehäuserahmens (1) liegt.

2. Elektrisches Gerät nach Anspruch 1, **dadurch gekennzeichnet, daß**
- die Stege (6) jeweils einen vorgegebenen Betrag quer zur jeweiligen Gehäuserahmenwand in das Gehäuse hineinragen.

3. Elektrisches Gerät nach Anspruch 1 oder 2, **dadurch gekennzeichnet, daß**
- die Stege (7) jeweils in einem vorgegebenen Abstand parallel zur jeweiligen Gehäuserahmenwand verlaufen.

4. Elektrisches Gerät nach einem der Ansprüche 1 bis 3, **dadurch gekennzeichnet, daß**
- der Gehäuserahmen (1) mit dem Gehäuseboden (2) fest verschraubbar ist.

5. Elektrisches Gerät nach einem der Ansprüche 1 bis 4, **dadurch gekennzeichnet, daß**
- die Leistungsbauelemente (4) mittels metallischer Klammern (8) an den Stegen (6,7) angedrückt sind.

6. Elektrisches Gerät nach einem der Ansprüche 1 bis 5, **dadurch gekennzeichnet, daß**
- der Gehäuseboden (2) Bestandteil einer elektromechanischen Anordnung ist und zusätzlich Rippen (9) zur Wärmeabfuhr aufweist.

## Claims

1. Electrical device, having an electronic circuit which is arranged at least partially on a printed circuit board (3), wherein the circuit has power components (4) each having an arrangement for heat dissipation, characterized in that the device has a housing frame (1) for the electronic circuit, in that the housing frame (1) has a number of webs (6, 7) which are connected to the respective housing frame wall but are offset and against which the heat-carrying housing parts of the power components (4) are held in thermal contact, in that the housing frame (1) can be attached with thermal contact to a heat-dissipating housing base (22), and in that the printed circuit board (3) of the electronic circuit rests on that side of the housing frame (1) which is opposite the housing base (2) of the electromechanical arrangement.

2. Electrical device according to Claim 1, characterized in that
- the webs (6) each project by a predetermined amount into the housing, transversely to the respective housing frame wall.

3. Electrical device according to Claim 1 or 2, characterized in that
- the webs (7) each run with a predetermined spacing parallel to the respective housing frame wall.

4. Electrical device according to one of Claims 1 to 3, characterized in that
- the housing frame (1) can be firmly screwed to the housing base (2).

5. Electrical device according to one of Claims 1 to 4, characterized in that
- the power components (4) are pressed against the webs (6, 7) by means of metallic clips (8).

6. Electrical device according to one of Claims 1 to 5, characterized in that
- the housing base (2) is a component of an electromechanical arrangement and has additional ribs (9) for heat dissipation.

## Revendications

1. Appareil électrique comprenant un circuit électronique, disposé au moins en partie sur une carte imprimée (3), le circuit présentant des composants de puissance (4) avec respectivement un agencement servant à évacuer la chaleur, caractérisé en ce que
• l'appareil présente un cadre de boîtier (1) pour le circuit électronique,
• le cadre de boîtier (1) présente un certain nombre d'entretoises (6, 7) reliées à la paroi correspondante du cadre de boîtier, mais décalées, entretoises sur lesquelles les parties des boîtiers des composants de puissance (4) qui conduisent la chaleur, sont maintenues en contact thermique,
• le cadre du boîtier (1) peut être relié par contact thermique à un fond du boîtier (22) qui évacue la chaleur, et
• la carte imprimée (3) du circuit électronique repose sur le côté du cadre du boîtier (1) qui est opposé au fond du boîtier (2) de l'agencement électromécanique.

2. Appareil électrique selon la revendication 1,
caractérisé en ce que
les entretoises (6) pénètrent d'un montant prédéfini dans le boîtier perpendiculairement à la paroi correspondante du cadre du boîtier.

3. Appareil électrique selon la revendication 1 ou 2,
caractérisé en ce que
les entretoises (7) s'étendent respectivement à une distance prédéfinie parallèlement à la paroi correspondante du cadre du boîtier.

4. Appareil électrique selon l'une des revendications 1 à 3,
caractérisé en ce que
le cadre du boîtier (1) peut être vissé de façon solidaire avec le fond du boîtier (2).

5. Appareil électrique selon l'une des revendications 1 à 4,
caractérisé en ce que
les composants de puissance (4) sont pressés au moyen d'agrafes métalliques (8)contre les entretoises (6, 7).

6. Appareil électrique selon l'une des revendications 1 à 5,
caractérisé en ce que
le fond du boîtier (2) fait partie d'un agencement électromécanique et présente en outre des nervures (9) pour évacuer la chaleur.
